## Europäisches Patentamt
## European Patent Office
## Office européen des brevets

(11) Veröffentlichungsnummer: **0 221 383**
**A1**

(12) # EUROPÄISCHE PATENTANMELDUNG

(21) Anmeldenummer: **86113913.7**

(22) Anmeldetag: **07.10.86**

(51) Int. Cl.⁴: **G 01 R 31/00**
**G 08 C 23/00**

(30) Priorität: **31.10.85 DE 3538687**

(43) Veröffentlichungstag der Anmeldung:
**13.05.87 Patentblatt 87/20**

(84) Benannte Vertragsstaaten:
**DE FR GB NL**

(71) Anmelder: **ROBERT BOSCH GMBH**
**Postfach 50**
**D-7000 Stuttgart 1(DE)**

(72) Erfinder: **Breckel, Werner, Dipl.-Ing. (FH)**
**Austrasse 8**
**D-7317 Wendlingen(DE)**

(72) Erfinder: **Schlienz, Ulrich, Dipl.-Ing.**
**Erlenstrasse 2**
**D-7333 Ebersbach-Rosswälden(DE)**

(54) **Testeinrichtung.**

(57) Es wird eine Testeinrichtung für Vorrichtungen in Kraftfahrzeugen vorgeschlagen, mit der insbesondere elektrische Einrichtungen im Kraftfahrzeug zu überprüfen sind. Die von den Meßsensoren (1-3) aufgenommenen Signale werden zu einem Sender (4) gegeben, der die Meßsignale drahtlos zur eigentlichen Testeinrichtung (5) überträgt. Durch diese Maßnahme wird erreicht, daß das Fahrzeug zu Diagnosezwecken bewegt werden kann und der Meßvorgang nicht durch herumhängende Kabel gestört wird. Die Diagnose an einem Fahrzeug wird daher insbesondere in Kraftfahrzeugwerkstätten wesentlich erleichtert.

FIG. 1

R. 20284
24.10.1985, Fd/Le

0221383

ROBERT BOSCH GMBH, 7000 STUTTGART 1

<u>Testeinrichtung</u>

Stand der Technik

Die Erfindung geht aus von einer Testeinrichtung nach der
Gattung des Hauptanspruchs. Testeinrichtungen zum Überprüfen von Funktionen von elektrischen Geräten in Kraftfahrzeugen sind bereits vielfältig bekannt. Mittels dieser
Testeinrichtungen sind beispielsweise der Schließwinkel oder
der Zündzeitpunkt einer Zündvorrichtung im Kraftfahrzeug
zu bestimmen oder es wird die Einspritzung und die dazugehörige Elektronik überprüft. Weitere Testeinrichtungen
ermöglichen die Überprüfung der Beleuchtungsanlage des
Kraftfahrzeugs, des Reglers der Lichtmaschine oder der
Steuerung für ein Antiblockiersystem. Zur eigentlichen
Durchführung der Messung ist bei bekannten Vorrichtungen
die Testeinrichtung über eine Vielzahl von Kabeln mit
dem Fahrzeug verbunden. In der DE-OS 34 10 752 ist bereits vorgeschlagen worden, die Zahl der Kabel, die von
der Testeinrichtung zum Kraftfahrzeug führen zu reduzieren.
Dies geschieht dort durch eine Aufbereitung der Meßsignale,
so daß sie beispielsweise als digitale Signale über eine
einzige Leitung zur Testeinrichtung übertragbar sind.

...

Dadurch wird zwar der Kabelaufwand wesentlich reduziert, es bleibt jedoch die Tatsache bestehen, daß die Testeinrichtung und das Fahrzeug nicht unabhängig voneinander aufgestellt werden können. Vielmehr besteht zwischen der Testeinrichtung und dem Fahrzeug immer noch die Verbindung mit einem Kabel.

Vorteile der Erfindung

Die erfindungsgemäße Testeinrichtung mit den kennzeichnenden Merkmalen des Hauptanspruchs hat demgegenüber den Vorteil, daß eine feste Verbindung zwischen der Testeinrichtung und dem Fahrzeug nicht mehr nötig ist. Das Fahrzeug ist daher bezüglich seines Aufstellungsortes im Bezug zur Testeinrichtung frei disponierbar. Als weiterer Vorteil ist anzusehen, daß das Fahrzeug zu Diagnosezwecken bewegbar ist. Als weiterer Vorteil ist anzusehen, daß kein Kabelwirrwarr auftreten kann. Dadurch wird erreicht, daß die Arbeit beispielsweise in Kraftfahrzeugwerkstätten sicherer wird, da nicht zu befürchten ist, daß Mitarbeiter über ausliegende Kabel stolpern und dadurch selbst zu Schaden kommen oder die oft teuren Meßgeräte beschädigen.

Durch die in den Unteransprüchen aufgeführten Maßnahmen sind vorteilhafte Weiterbildungen und Verbesserungen der im Hauptanspruch angegebenen Testeinrichtung möglich. So ist es vorteilhaft, die Signale der Geber zeitmultiplex zu übertragen. Dadurch wird erreicht, daß mittels eines Senders eine Vielzahl von Gebersignalen zu übertragen sind. Dadurch können eine Vielzahl von Signalen am Motor gleichzeitig abgegriffen und in der Testeinrichtung ausgewertet

...

werden. Alternativ hierzu ist ebenfalls eine frequenzmultiplexe Übertragung möglich. Hierbei wird jedem Sensor ein eigener Kanal zugeordnet, wobei die Übermittlung entweder mittels eines Sensors mit mehreren Kanälen oder aber mittels mehreren Sendern möglich ist. Vorteilhaft an dieser Anwendung ist, daß beispielsweise jedem Geber ein Sender zuzuordnen ist, wobei vorteilhafterweise Geber und Sender eine räumliche Einheit bilden. Dadurch wird erreicht, daß Geber und Sender optimal aufeinander anpaßbar sind und bei geeigneter Ausgestaltung nur ein geringes Volumen einnehmen, so daß die Sensoren leicht auch an schwer zugänglichen Stellen anbringbar sind. Vorteilhaft ist weiterhin, daß verschiedene Testeinrichtungen lediglich die Signale und Kanäle empfangen müssen, die sie betreffen. Selbstverständlich schließt eine frequenzmultiplexe Übertragung nicht aus, daß durch einen Sender beispielsweise auch Signale von zwei Sensoren übertragen werden, wenn beispielsweise diese Sensoren räumlich benachbart angeordnet werden müssen.

Zeichnung

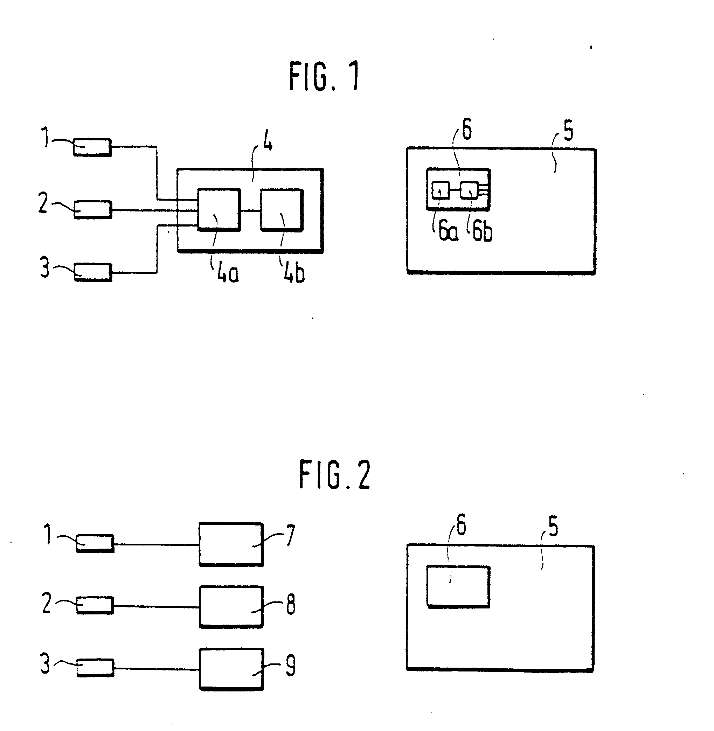

Ausführungsbeispiele der Erfindung sind in der Zeichnung dargestellt und in der nachfolgenden Beschreibung näher erläutert. Es zeigen Figur 1 ein erstes Ausführungsbeispiel und Figur 2 ein zweites Ausführungsbeispiel der Erfindung.

Beschreibung der Ausführungsbeispiele

Figur 1 zeigt drei Sensoren 1, 2 und 3, die beispielsweise an verschiedenen Punkten des Kraftfahrzeuges anzuschließen sind. Beispielsweise handelt es sich bei dem Geber 1 um eine

...

Triggerzange, um Zündimpulse in ein Zündkabel abzugreifen, bei dem Sensor 2 um einen Spannungsmesser, der geeignet ist, die Bordspannung in einem Fahrzeug zu messen, und beim Sensor 3 um einen Strommesser, mit dem der Strom in einem Teil des Bordnetzes des Kraftfahrzeuges zu messen ist. Die drei Sensoren 1, 2 und 3 sind jeweils an einem Eingang des Senders 4 angeschlossen. Der Sender 4 weist beispielsweise einen Multiplexer und Kodierer 4a auf, der die Sensorsignale der Sensoren 1, 2 und 3 zeitmultiplex an den Sender 4b überträgt. Der Sender 4b ist nun mit Signalen moduliert, die hintereinander den Signalen der Sensoren 1, 2 und 3 entsprechen. Diese Signale werden von einem Empfänger 6 aufgefangen, der in der Testeinrichtung 5 untergebracht ist. Bei der Testeinrichtung 5 handelt es sich beispielsweise um einen Motortester. Der Empfänger 6 besteht aus dem eigentlichen Empfänger 6a und einem Demultiplexer 6b, der die drei vom Empfänger 6a empfangenen Signale wiederum auftrennt, und sie den einzelnen Eingängen des Motortesters 5 zuführt. Es ist auch ohne weitere Erklärung verständlich, daß je nach der Häufigkeit der Datenübertragung auch wesentlich mehr Sensoren an den Sender 4 angeschlossen werden können und vom Empfänger 6 ausgewertet werden können. In der Testeinrichtung 5 werden die vom Empfänger 6 aufgenommenen Signale in bekannter Art und Weise verarbeitet.

Die Übertragungsfrequenz ist weitgehend beliebig. Diese kann im Langwellen- oder Ultrakurzwellenbereich oder aber auch im Gigahertzbereich liegen. Weiterhin ist es möglich, eine Signalübertragung beispielsweise durch Ultraschall- oder durch Infrarotsignale vorzunehmen.

. . .

In dem in Figur 2 dargestellten Ausführungsbeispiel ist
jedem Sensor 1, 2 und 3 ein eigener Sender 7, 8 und 9 zugeordnet. Dies bietet die Möglichkeit, den Sensor 1 beispielsweise mit dem Sender 7 zu einer räumlichen Einheit
zu vereinigen, so daß beispielsweise der Sender 7 mit
seiner Stromversorgung in einem Griff der Triggerzange 1
untergebracht ist. Die Sender 7, 8 und 9 senden jeweils
auf getrennten Kanälen, die ihnen in einen Frequenzbereich zugeordnet sind. Hierdurch ist es möglich, die
Gebersignale gleichzeitig zu übertragen. Es ist ohne
Schierigkeiten erkenntlich, daß die Sender 7, 8 und 9
auch zusammengefaßt werden können, so daß eine kanalweise Übertragung mittels eines einzigen Senders möglich ist. Hierbei werden die Signale z.B. auf Hilfsträger moduliert, ähnlich wie es beim UKW-Rundfunk gemacht wird. Der Empfänger 6 in der Testeinrichtung 5
ist nun so aufgebaut, daß er die Kanäle empfangen kann,
die für die entsprechende Testeinrichtung von Interesse
sind. Werden von der Testeinrichtung 5 beispielsweise
nur die Signale der Geber 1 und 3 benötigt, so ist es
hinreichend, wenn der Empfänger 6 die Kanäle der Sender
7 und 9 empfangen kann. Der Kanal des Senders 8 ist beispielsweise nur von einem speziellen Empfänger empfangbar,
der dieses Signal für ein besonderes Testgerät benötigt.

Durch die Testeinrichtung ist es möglich, ohne störende
Kabel Meßsignale vom Meßort zur Testeinrichtung zu übertragen. Dadurch wird erreicht, daß Fahrzeuge während der
Diagnose bewegt werden können und bezüglich der Testeinrichtung im weiten Bereich beliebig angeordnet sein können.
Zudem stören beim Meßvorgang nicht vom und zum Fahrzeug
führende Kabel.

R. 20284
24.10.1985, Fd/Le

\

0221383

ROBERT BOSCH GMBH, 7000 STUTTGART 1

Ansprüche

1. Testeinrichtung für Vorrichtungen in Kraftfahrzeugen, insbesondere Motortester, mit mindestens einem im Kraftfahrzeug anbringbaren Geber, dessen Signale der Testeinrichtung zugeführt sind, dadurch gekennzeichnet, daß die Signale der Geber (1, 2, 3) mindestens einem Sender (4) zugeführt sind und daß die Testeinrichtung (5) ein zum Sender (4) korrespondierender Empfänger (6) aufweist.

2. Testeinrichtung nach Anspruch 1, dadurch gekennzeichnet, daß die Signale der Geber (1 - 3) zeitmultiplex übertragen werden.

3. Testeinrichtung nach Anspruch 1, dadurch gekennzeichnet, daß die Signale der Geber (1 - 3) frequenzmultiplex übertragen werden.

4. Testeinrichtung nach Anspruch 3, dadurch gekennzeichnet, daß für jeden Geber (1 - 3) ein Sender (7 - 9) vorgesehen ist.

5. Testeinrichtung nach Anspruch 4, dadurch gekennzeichnet, daß mindestens ein Geber (1 - 3) und ein Sender (7 - 9) eine räumliche Einheit bilden.

## FIG. 1

## FIG.2

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl 4) |
|---|---|---|---|
| X | DE-A-2 732 626  (NIPPON SOKEN INC.)<br>* Seite 4, Zeilen 1-6;  Seite 4, Zeile 32 - Seite 5, Zeile 2; Seite 7, Zeilen 23-34;  Seite 9, Zeilen 6-29;  Seite 13, Zeilen 26-30; Figuren 2,5 * | 1-3 | G 01 R   31/00<br>G 08 C   23/00 |
| Y |  | 4,5 |  |
| | --- | | |
| Y | GB-A-2 047 932  (GOULD INC.)<br>* Seite 2, Zeilen 20-44;  Figuren 1,2 * | 4,5 | |
| | --- | | |
| A | DE-A-1 929 044  (D.HIRT et al.)<br>* Patentansprüche 1,4 * | 1,2 | |
| | --- | | RECHERCHIERTE SACHGEBIETE (Int. Cl 4) |
| A | DE-A-3 129 471  (I.VATHAUER)<br>* Patentansprüche 1,2; Figur 1 * | 1 | G 01 R<br>G 08 C<br>G 01 M |
| | ----- | | |

Der vorliegende Recherchenbericht wurde für alle Patentansprüche erstellt

| Recherchenort<br>DEN HAAG | Abschlußdatum der Recherche<br>05-02-1987 | Prüfer<br>PENZKOFER, B. |
|---|---|---|

EPA Form 1503 03 82

KATEGORIE DER GENANNTEN DOKUMENTE
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument